# EUROPEAN PATENT SPECIFICATION

(11) **EP 4 250 877 B1**
(45) Date of publication and mention of the grant of the patent: **25.02.2026**
(21) Application number: 22197890.1
(22) Date of filing: 27.09.2022
(51) Int. Cl.: H05K 1/02

(54) **FLEXIBLE CONNECTING MEMBER AND ELECTRONIC DEVICE INCLUDING THE SAME**
FLEXIBLES VERBINDUNGSELEMENT UND ELEKTRONISCHE VORRICHTUNG DAMIT
ÉLÉMENT DE CONNEXION FLEXIBLE ET DISPOSITIF ÉLECTRONIQUE LE COMPRENANT

(30) Priority: 22.03.2022 KR 20220035301; 11.04.2022 KR 20220044729
(43) Date of publication of application: 27.09.2023
(73) Proprietor: Samsung Electronics Co., Ltd., Suwon-si, Gyeonggi-do 16677 (KR)
(72) Inventor: Bae, Bumhee, Suwon-si, Gyeonggi-do 16677 (KR); Kim, Myunghoi, Anseong-si, Gyeonggi-do 17579 (KR); Kim, Minseok, Suwon-si, Gyeonggi-do 16677 (KR); Kim, Younho, Suwon-si, Gyeonggi-do 16677 (KR); Shim, Jongwan, Suwon-si, Gyeonggi-do 16677 (KR); Yang, Kwangmo, Suwon-si, Gyeonggi-do 16677 (KR); Cheon, Jeongnam, Suwon-si, Gyeonggi-do 16677 (KR)
(74) Representative: Gulde & Partner

(56) References cited:
- US-A1- 2018 053 981
- US-A1- 2020 359 493
- US-A1- 2020 413 527
- US-B1- 6 674 347

## Description

### TECHNICAL FIELD

Various embodiments disclosed herein relate to a flexible connecting member and an electronic device including the same.

### BACKGROUND

With the increase of degree of integration of electronic devices and the generalization of ultra-high-speed, high-capacity wireless communication, multiple functions have recently come to be provided in a single electronic device, such as a mobile communication terminal. For example, various functions, such as an entertainment function (e.g., a game function), a multimedia function (e.g., music/video playback), a communication and security function for mobile banking or the like, a schedule management function, and an e-wallet function, have come to be integrated in a single electronic device, in addition to a communication function. In addition, electronic devices are increasingly equipped with wider display panels so that users do not have any inconvenience in using multimedia services. In recent years, foldable and/or rollable electronic devices in each of which a flexible display panel is disposed have become available. A foldable and/or rollable electronic device may refer to an electronic device that includes a plurality of housing structures which relatively move with respect to each other.

Meanwhile, circuit boards as components disposed in an electronic device may be classified into a rigid circuit board and a flexible printed circuit board depending on physical characteristics related to the flexibility thereof. In recent years, a rigid-flexible printed circuit board (hereinafter referred to as a "flexible printed circuit board"), in which a rigid circuit board and a flexible printed circuit board are combined so as to increase the reliability of electrical connection of an electronic device and to implement three-dimensional wiring, has also been used.

Since the commercialization of 4^{th} generation (4G) communication systems, in order to meet the increasing demand for wireless data traffic, development and distribution of next generation (5G) communication systems have been actively carried out. In order to achieve a high data transmission rate, the 5G communication systems use an ultra-high frequency of several tens of GHz or higher (or referred to as "mmWave communication"). However, in an electronic device including an ultra-high frequency communication module, performance exhibited by the communication module may be affected by a path (e.g., a wire) through which a communication signal is transmitted due to high frequency characteristics.

US 2020/359493 A1 discloses a cable where signals are prevented from being emitted from at least one transmission line from in a direction of an air gap.

US 2018/053981 A1 disclose a flexible flat cable where a crosstalk of a signal due to an external signal may be reduced.

US 6674347 B1 discloses a multi-layer substrate forsuppressing an unwanted transmission mode ,e.g., in a high frequency region.

### SUMMARY

In an electronic device, various electric elements (or electronic components) and a printed circuit board on which the various electric elements are mounted are disposed inside a component-mounting bracket. In the case of a foldable and/or rollable electronic device, the electric elements and the printed circuit board may be separately disposed in a plurality of housing structures based on a consideration of various factors such as space mountability, communication performance, and heat dissipation performance. In this case, a flexible printed circuit board, which is easy to bend, may be used in order to connect respective electric elements.

Since at least a portion of the flexible printed circuit board is flexibly bendable, the flexible printed circuit board may be highly utilized in a narrow space and may be suitable for use in a configuration that interconnects electric elements contained inside a housing structure and electric elements contained inside another housing structure, but it may be necessary to make additional considerations in terms of durability and service life. According to some embodiments, when a foldable and/or rollable electronic device is repeatedly folded and unfolded, stress due to friction with a housing, a component, or another board accumulates in a bending portion of a flexible printed circuit board, which may result in damage. In addition, according to repeated use of the foldable and/or rollable electronic device, the lifespan of the bending portion may be shortened.

According to various embodiments of the disclosure, even when a foldable and/or rollable electronic device is repeatedly used, it is possible to improve the lifespan of the bending portion of a flexible printed circuit board mounted in the electronic device.

The invention is set out in the appended set of claims.

Various embodiments of the invention provide a flexible connecting member, in particular a flexible printed circuit board (FPCB), including: a first protective layer; a wiring layer disposed under the first protective layer; and a second protective layer disposed under the wiring layer, wherein the wiring layer includes a support layer configured to support a plurality of wires and a dielectric layer that at least partially covers the plurality of wires, and the plurality of wires include a first ground wire disposed on the support layer, a second ground wire disposed in parallel with the first ground wire, a first signal wire disposed between the first ground wire and the second ground wire, a second signal wire disposed between the first ground wire and the second ground wire, and a common ground wire disposed between the first signal wire and the second signal wire, and wherein, when viewed from above the flexible connecting member, the dielectric layer includes a permittivity change area formed to at least partially overlap the common ground wire, and the permittivity change area has a permittivity different from that of the dielectric layer around the permittivity change area, wherein the permittivity change area has a width greater than a width of the common ground wire, but smaller than a width between the first signal wire and the second signal wire.

The permittivity change area may mean an area having a permittivity different from that of the peripheral area, preferably a permittivity different from that of the dielectric layer. Thus, in other words, the permittivity change area may mean an area where there is a change in permittivity compared to the peripheral area, preferably compared to the surrounding dielectric layer. The permittivity change area may have the form of a channel formed in the dielectric layer. The permittivity change area preferably extends in parallel to the common ground wire along the common ground wire thereby overlapping the common ground wire along its complete length or at least along a part of its length.

According to various embodiments of the disclosure, it is possible to provide a foldable and/or rollable electronic device in which a flexible printed circuit board mounted in the electronic device allows for reduced crosstalk between signal wires and has a reduced (metal) density improving durability against bending. In particular, by providing the permittivity change area, it is possible to reduce crosstalk between the two signal wires thanks to the different permittivity with respect to the surrounding material while maintaining a sufficient durability of the flexible connecting member against bending. In addition to this, various effects may be provided.

According to an embodiment, the permittivity change area is formed by removing at least a portion of the dielectric layer. Removing such portion of the dielectric layer may result in a gap or channel being formed in the dielectric layer. The permittivity change area may be provided by this gap. In other words, this gap, in particular material arranged in this gap, may have a different permittivity to the surrounding material, in particular to the dielectric layer. According to an embodiment, the permittivity change area is formed of a material different from a material of the dielectric layer around the permittivity change area. Such different material may be arranged inside the gap formed in the dielectric layer. Such different material may be another dielectric material. According to an embodiment, the permittivity change area is filled with air. Thus, the different material arranged inside the gap formed by the dielectric layer may be air. In the alternative, any other material having a different permittivity than the surrounding material, in particular to the dielectric layer, may be provided in the gap. Forming the permittivity change area by removing at least a portion of the dielectric layer allows for a particularly simple production of the flexible connecting member. This is true in particular if the gap is simply filled with air as, in this case, no other material needs to be inserted into the gap. Further, such a permittivity change area reduces the material density of the dielectric layer and thus of the flexible connecting member which improves the durability of the flexible connecting member against bending. Therefore, an effective reduction of crosstalk between the signal wires may be achieved while at the same time improving the durability of the flexible connecting member against bending.

According to an embodiment, the permittivity change area has a permittivity lower than a permittivity of the dielectric layer around the permittivity change area. This allows for a particularly effective reduction of crosstalk between the signal wires.

According to the invention, the permittivity change area has a width greater than a width of the common ground wire. This allows for a particularly effective reduction of crosstalk between the signal wires.

According to the invention, the permittivity change area has a width greater than a width of the common ground wire, but smaller than a width between the first signal wire and the second signal wire. For example, the width between the first signal wire and the second signal wire may be a minimum or maximum distance between the first signal wire and the second signal wire. Thus, according to an embodiment, the permittivity change area has a width smaller than a distance between an inner edge of the first signal wire and an inner edge of the second signal or, alternatively, smaller than a distance between an outer edge of the first signal wire and an outer edge of the second signal wire. This allows for crosstalk to be effectively reduced between the signal wires with low production effort.

According to an embodiment, the permittivity change area has a depth determined in consideration of a signal transmission characteristic of the flexible connecting member. Thus, the depth of the permittivity change area is chosen such that a preferred signal transmission characteristic is achieved, in particular such that a sufficient crosstalk reduction performance is achieved. According to an embodiment, the depth of the permittivity change area is determined to be less than a length obtained by subtracting a thickness of the common ground wire from a maximum thickness of the dielectric layer such that the common ground wire is not exposed to outside of the dielectric layer. In other words, the depth of the permittivity change area is determined to be about 30% or more to less than 100% of a remaining thickness obtained by excluding the thickness of the ground wire from the total thickness of the dielectric layer. For example, the depth may be about 30% to about 90% of the remaining thickness, preferably about 40% to about 90% of the remaining thickness. Providing the permittivity change area with a depth determined in consideration of a signal transmission characteristic of the flexible connecting member allows for a sufficient reduction of crosstalk between the signal wires while still covering and thus protecting the common ground wire.

According to an embodiment, the first protective layer and the wiring layer are spaced apart from each other by a predetermined distance. According to an embodiment, the wiring layer and the second protective layer are spaced apart from each other by a predetermined distance. This allows for a simple manufacture, in particular a standardized manufacture, and for a simple and secure embedding of the wiring layer.

Further embodiments of the invention provide an electronic device including a housing; and a flexible connecting member as explained above, the flexible connecting member being disposed inside the housing. Thus, embodiments of the invention provide an electronic device including: a housing; and a flexible connecting member disposed inside the housing, wherein the flexible connecting member includes a first protective layer, a wiring layer disposed under the first protective layer, and a second protective layer disposed under the wiring layer, wherein the wiring layer includes a support layer configured to support a plurality of wires and a dielectric layer that at least partially covers the plurality of wires, and the plurality of wires include a first ground wire disposed on the support layer, a second ground wire disposed in parallel with the first ground wire, a first signal wire disposed between the first ground wire and the second ground wire, a second signal wire disposed between the first ground wire and the second ground wire, and a common ground wire disposed between the first signal wire and the second signal wire, and wherein, when viewed from above the flexible connecting member, the dielectric layer includes a permittivity change area formed to at least partially overlap the common ground wire, and the permittivity change area has a permittivity different from that of the dielectric layer around the permittivity change area.

### BRIEF DESCRIPTION OF THE DRAWINGS

The above and other aspects, features, and advantages of the disclosure will be more apparent from the following detailed description taken in conjunction with the accompanying drawings, in which:
FIG. 1 is a block diagram of an electronic device according to various embodiments in a network environment;
FIG. 2 is a view illustrating the state in which an electronic device according to various embodiments of the disclosure is unfolded;
FIG. 3A is a cross-sectional view illustrating the unfolded state in which the display part of the electronic device according to some embodiments is fully unfolded, and FIG. 3B is a cross-sectional view illustrating the intermediate state in which the display part of the electronic device according to some embodiments is partially unfolded;
FIG. 4 is an exploded perspective view of an electronic device according to various embodiments of the disclosure;
FIG. 5 is a view illustrating a portion of the inside of an electronic device according to various embodiments of the disclosure;
FIG. 6 is a view illustrating flexible connecting members according to various embodiments of the disclosure;
FIGS. 7A and 7B are views illustrating an implemented example of a flexible connecting member according to a first embodiment, which is not covered by the claims, in which FIG. 7A is a top view illustrating the flexible connecting member according to the first embodiment viewed in parallel to the X axis, and FIG. 7B is a view illustrating a cross section taken along line C-C' in FIG. 7A;
FIG. 8 is a view illustrating an S-parameter of a flexible connecting member according to the first embodiment;
FIGS. 9A and 9B are views illustrating an implemented example of a flexible connecting member according to a second embodiment, which is an embodiment of the claimed invention, in which FIG. 9A is a top view illustrating the flexible connecting member according to the second embodiment viewed in parallel to the X axis, and FIG. 9B is a view illustrating a cross section taken along line D-D' in FIG. 9A;
FIG. 10 is a view illustrating NEXT and FEXT test results of the flexible connecting member according to the second embodiment;
FIGS. 11 is a view illustrating crosstalk performance of the flexible connecting member according to the second embodiment in a time domain;
FIGS. 12A and 12B are views illustrating an implemented example of a flexible connecting member according to a third embodiment, which is not covered by the claims, in which FIG. 12A is a top view illustrating the flexible connecting member according to the third embodiment viewed in parallel to the X axis, and FIG. 12B is a view illustrating a cross section taken along line E-E' in FIG. 12A; and
FIG. 13 is a view illustrating NEXT and FEXT test results of the flexible connecting member according to the third embodiment.

### DETAILED DESCRIPTION

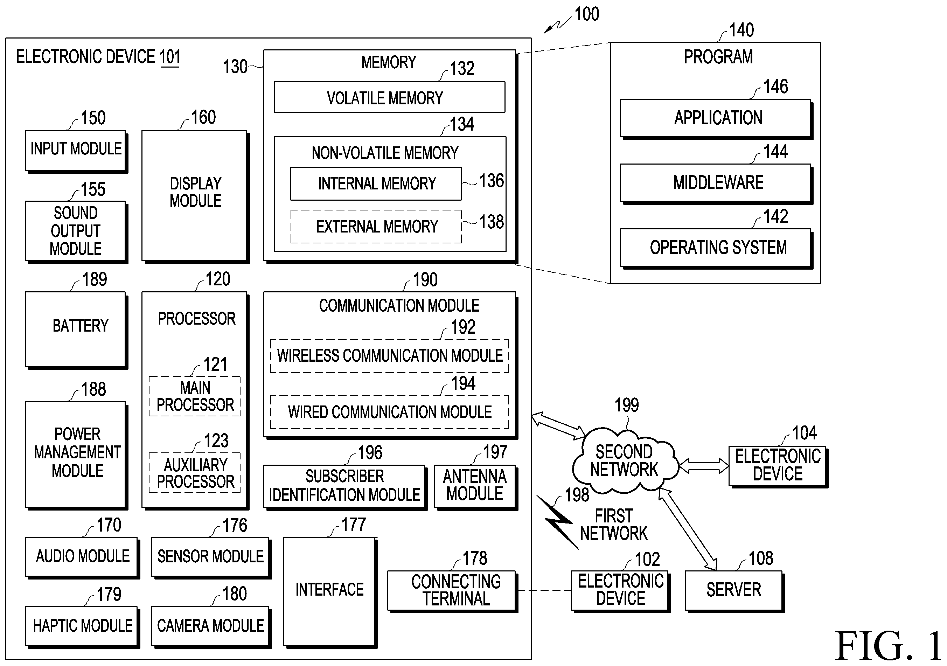

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence model is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments not covered by the claims may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, which is not covered by the claims, a method may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

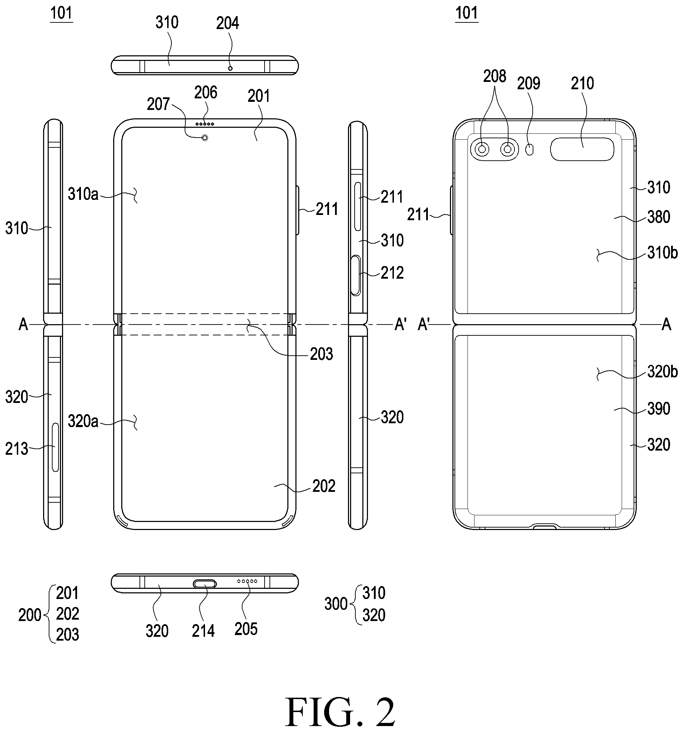

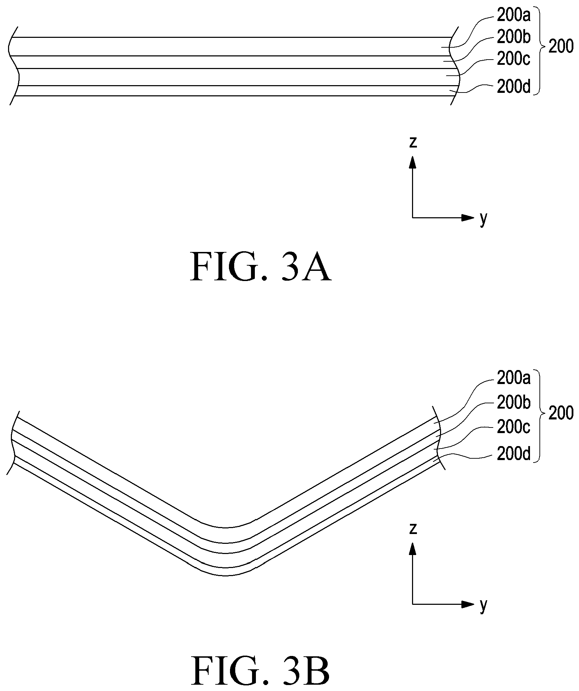

FIG. 2 is a view illustrating the state in which an electronic device 101 according to various embodiments is unfolded. FIG. 2 illustrates various views illustrating the front, rear, and side surfaces of the electronic device 101 together. FIG. 3A is a cross-sectional view illustrating the state in which the display part of the electronic device 101 according to an embodiment is fully unfolded, and FIG. 3B is a cross-sectional view illustrating the intermediate state in which the display part of the electronic device 101 according to an embodiment is partially unfolded.

Referring to FIG. 2, an electronic device 101 according to an embodiment may include a foldable housing 300 and a flexible or foldable display 200 (hereinafter, simply referred to as a "display" 200) (e.g., the display module 160 in FIG. 1) disposed in a space defined by the foldable housing 300.

According to an embodiment, the surface on which the display 200 is disposed may be defined as the front surface of the electronic device 101. According to an embodiment, at least a portion of the front surface of the electronic device 101 may be formed of a substantially transparent front plate (e.g., a glass plate or a polymer plate including various coating layers). In addition, the surface opposite to the front surface may be defined as the rear surface of the electronic device 101. The rear surface of the electronic device 101 may be formed of a substantially opaque rear plate (hereinafter, referred to as a "rear cover"). The rear cover may be formed of, for example, coated or colored glass, ceramic, a polymer, a metal (e.g., aluminum, stainless steel (STS), or magnesium), or a combination of at least two of these materials. The surface surrounding the space between the front surface and the rear surface may be defined as the side surface of the electronic device 101. The side surface may be defined by a side bezel structure (or a "side member") coupled to the front plate and the rear plate and including a metal and/or a polymer. In some embodiments, the rear cover and the side bezel structure may be integrally configured, and may include the same material (e.g., a metal material such as aluminum).

The electronic device 101 may include at least one of a display 200, audio modules 204, 205, and 206, a sensor module 209, camera modules 207 and 208, key input devices 211, 212, and 213, and a connector hole 214. According to an embodiment, in the electronic device 101, at least one of the components (e.g., the key input devices 211, 212, and 213) may be omitted, or other components (e.g., a light-emitting element) may be additionally included.

According to various embodiments, the display 200 may be a display, at least a partial area of which is deformable into a flat surface or a curved surface. According to an embodiment, the display 200 may include a folding area 203, a first area 201 disposed on one side of the folding area 203 (e.g., the upper side of the folding area 203 illustrated in FIG. 2), and a second area 202 disposed on the other side of the folding area 203 (e.g., the lower side of the folding area 203 illustrated in FIG. 2). However, the area division of the display 200 illustrated in FIG. 2 is exemplary, and the display 200 may be divided into multiple (e.g., four or more or two) areas depending on the structures or functions thereof. For example, in the embodiment illustrated in FIG. 2, the areas of the display 200 may be divided with reference to the folding area 203 or a folding axis A-A'. However, in another embodiment, the areas of the display 200 may be divided with reference to another folding area or another folding axis (e.g., a folding axis perpendicular to the folding axis A-A').

According to various embodiments, the audio modules 204, 205, and 206 may include a microphone hole 204 and speaker holes 205 and 206. The microphone hole 204 may include a microphone disposed therein to acquire external sound, and in some embodiments, a plurality of microphones may be disposed therein to be able to detect the direction of sound. The speaker holes 205 and 206 may include an external speaker hole 205 and a call receiver hole 206. In some embodiments, while implementing the speaker holes 205 and 206 and the microphone hole 204 as a single hole, or without the speaker holes 205 and 206, a speaker (e.g., a piezo speaker) may be included. The positions and number of microphone holes 204 and speaker holes 205 and 206 may be variable depending on embodiments.

According to various embodiments, the camera modules 207 and 208 may include a first camera device 207 disposed on the first surface 310a of the first housing 310 of the electronic device 101 and a second camera device 208 disposed on the second surface 310b. In addition, the electronic device 101 may further include a flash (not illustrated). The camera devices 207 and 208 may include one or more lenses, an image sensor, and/or an image signal processor. The flash (not illustrated) may include, for example, a light-emitting diode or a xenon lamp.

According to various embodiments, the sensor module 209 may generate an electrical signal or a data value corresponding to an internal operating state of the electronic device 101 or an external environmental state. Although not illustrated in the drawings, the electronic device 101 may additionally include another sensor module in addition to or instead of the sensor module 209 provided on the second surface 310b of the first housing 310. The electronic device 101 may include, as a sensor module, at least one of, for example, a proximity sensor, a fingerprint sensor, an HRM sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to various embodiments, key input devices 211, 212, and 213 may be disposed on the side surface of the foldable housing 300. In another embodiment, the electronic device 101 may not include some or all of the above-mentioned key input devices 211, 212, and 213, and the key input devices, which are not included in the electronic device 101, may be implemented in another form, such as soft keys, on the display 200. In some embodiments, the key input devices may be configured such that key inputs are implemented by sensor modules.

According to various embodiments, the connector hole 214 may be configured to accommodate a connector (e.g., a USB connector) configured to transmit and receive power and/or data to and from an external electronic device, and to accommodate, in addition to or instead of the connector, a connector configured to transmit and receive an audio signal to and from an external electronic device.

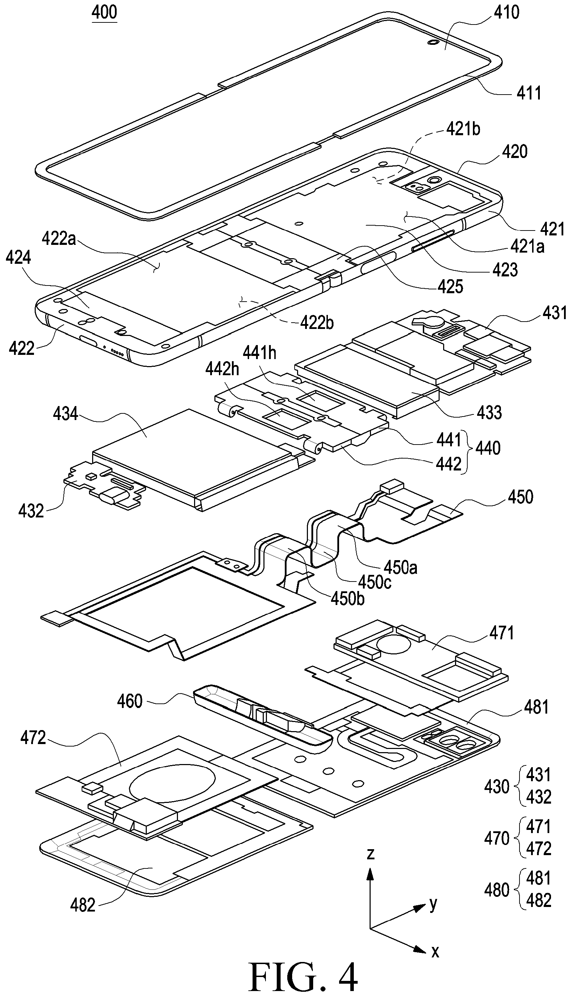

According to various embodiments, the foldable housing 300 may include a first housing structure 310, a second housing structure 320, a first rear cover 380, a second rear cover 390, and a hinge structure (e.g., the hinge structure 440 in FIG. 4 to be described later). The foldable housing 300 of the electronic device 101 is not limited to the shape and assembly illustrated in FIGS. 2, 3A and 3B, but may be implemented by a combination and/or an assembly of different shapes or components. For example, in another embodiment, the first housing structure 310 and the first rear cover 380 may be configured integrally with each other, and the second housing structure 320 and the second rear cover 390 may be configured integrally with each other. According to various embodiments, the term "housing structure" may be a combination and/or an assembly of various components, including a housing.

According to various embodiments, the first housing structure 310 may be connected to a hinge structure (e.g., the hinge structure 440 in FIG. 4 to be described later), and may include a first surface 310a oriented in a first direction and a second surface 310b oriented in a second direction opposite to the first direction. The second housing structure 320 may be connected to a hinge structure (e.g., a hinge structure 440 to be described with reference to FIG. 4), and may include a third surface 320a oriented in a third direction and a fourth surface 320b oriented in a fourth direction opposite the third direction. The second housing structure 320 is rotatable about the hinge structure (or the folding axis A-A') relative to the first housing structure 310.

According to various embodiments, the first housing structure 310 and the second housing structure 320 may be disposed on opposite sides (or upper and lower sides) about the folding axis A-A', and may have generally symmetrical shapes about to the folding axis A-A'. The first housing 310 and the second housing 320 may form an angle or a distance therebetween, which may be variable depending on whether the electronic device 101 is in an unfolded state, in a folded state, or in a partially unfolded (or partially folded) intermediate state. According to an embodiment, unlike the second housing structure 320, the first housing structure 310 may further include various sensors, but the first housing structure 310 and the second housing structure 320 may have mutually symmetrical shapes in other areas.

According to various embodiments, the first housing structure 310 and the second housing structure 320 may be at least partially made of a metal material or a non-metal material having rigidity of a level selected so as to support the display 200. At least a portion formed of the metal material may provide a ground plane of the electronic device 101, and may be electrically connected to a ground line provided on a printed circuit board (e.g., the printed circuit board 430 in FIG. 4).

According to various embodiments, the first rear cover 380 may be disposed on the rear surface of the electronic device 101 at one side of the folding axis A-A', and may have, for example, a substantially rectangular periphery, which may be enclosed by the first housing structure 310. Similarly, the second rear cover 390 may be disposed on the rear surface of the electronic device 101 at the other side of the folding axis A-A', and the periphery of the second rear cover 390 may be enclosed by the second housing structure 320.

According to various embodiments, the first rear cover 380 and the second rear cover 390 may have substantially symmetrical shapes about the folding axis A-A'. However, the first rear cover 380 and the second rear cover 390 do not necessarily have mutually symmetrical shapes, and in another embodiment, the electronic device 101 may include a first rear cover 380 and a second rear cover 390 having various shapes. In still another embodiment, the first rear cover 380 may be configured integrally with the first housing structure 310, and the second rear cover 390 may be configured integrally with the second housing structure 320.

According to various embodiments, the first rear cover 380, the second rear cover 390, the first housing structure 310, and the second housing structure 320 may define a space in which various components (e.g., a printed circuit board or a battery) of the electronic device 101 may be disposed. According to an embodiment, one or more components may be disposed or visually exposed on the rear surface of the electronic device 101. For example, at least a portion of a sub-display 210 may be visually exposed through the first rear cover 380. In another embodiment, one or more components or sensors may be visually exposed through the first rear cover 380. In various embodiments, the sensors may include a proximity sensor and/or a rear camera. Although not separately illustrated in the drawings, one or more components or sensors may be visually exposed through the second rear cover 390.

According to various embodiments, a front camera 207 exposed to the front surface of the electronic device 101 through one or more openings or a rear camera 208 exposed through the first rear cover 380 may include one or more lenses, an image sensor, and/or an image signal processor. The flash 209 may include, for example, a light-emitting diode or a xenon lamp. In some embodiments, two or more lenses (e.g., an infrared camera, a wide-angle lens, and a telephoto lens), and image sensors may be disposed on one surface of the electronic device 101. The front camera 207 may be disposed on the front side of the electronic device 101, and the display 210 may be disposed between an external portion of the electronic device 101 and the front camera 207. According to an embodiment, the front camera 207 may be configured as an under-display camera (UDC). The front camera 207 configured as the UDC may not be exposed to the outside. Accordingly, a hole provided for disposing the front camera 207 may not be recognized by a user, and an area of the display 210 disposed above the front camera 207 may implement a picture or an image.

The display 200 according to various embodiments will be described in more detail with reference to FIGS. 3A and 3B.

According to various embodiments, FIG. 3A may represent a fully unfolded state of the display part, and FIG. 3B may represent a partially unfolded state (or partially folded state) of the display part.

According to various embodiments, the display part of the electronic device 101 may include a configuration that displays a screen through a display and a configuration that is connected to the display and moves integrally with the display. Referring to FIG. 3A, the display part may include a display panel 200c and a touch panel 200d disposed adjacent to the display panel 200c.

The electronic device 101 may be variable to a folded state or an unfolded state. The electronic device 101 may be foldable in two types, i.e. an "in-folding" type in which the front surface of the electronic device 101 is folded to form an acute angle when viewed in the direction of the folding axis (e.g., A-A' in FIG. 2) and an "out-folding" type in which the front surface of the electronic device 101 is folded to form an obtuse angle when viewed in the direction of the folding axis. For example, in the electronic device 101, the first surface 310a may face the third surface 320a in the state in which the electronic device 101 is folded in the in-folding type, and the third direction may be substantially the same as the first direction in the fully unfolded state. As another example, in the state in which the electronic device 101 is folded in the out-folding type, the second surface 310b may face the fourth surface 320b.

The in-folding type may mean the type in which the display 200 is not exposed to the outside in the fully folded state. The out-folding type may mean the type in which the display 200 is exposed to the outside in the fully folded state. FIG. 3B illustrates an intermediate state in which the electronic device 101 is partially unfolded while being in-folded. Hereinafter, for convenience, the electronic device 101 will be described focusing on the state of being folded in the in-folding type, but it should be noted that this description is also applicable to the state in which the electronic device 101 is folded in the out-folding type.

According to some embodiments, the display 200 may include a display panel 200c, a polarizing layer 200b disposed on the display panel 200c, and a window member 200a defining the external appearance of the display. The display panel 200c, the polarizing layer 200b, and the window member 200a may constitute a single display 200, and may be formed of a flexible material. Accordingly, as illustrated in FIG. 3A, when an external force is applied in the state in which the display 200 is unfolded, the display 200 may be bent as illustrated in FIG. 3B. Alternatively, when an external force is applied in the state in which the display 200 is partially folded as illustrated in FIG. 3B, the display 200 may be unfolded as illustrated FIG. 3A.

According to various embodiments, the electronic device 101 may detect an input (e.g., a user input or an input made through the input device 150 in FIG. 1) on the surface of the display 200 by using the touch panel 200d. Here, the input that is recognizable by the touch panel 200d may include not only an input made through direct contact with the surface of the display 200, but also an input made through hovering. According to an embodiment, the touch panel 200d may have substantially the same area as the display 200. According to various embodiments, the touch panel 200d may be disposed on the top surface or the rear surface of the display 200. As an embodiment, FIGS. 3A and 3B illustrate the state in which the touch panel 200d is attached to the rear surface of the display 200.

According to an embodiment, the display device 200 may be at least partially made of a material that transmits radio waves or magnetic fields. Since the display 200 may be equipped with a display panel 200c and/or a touch panel 200d, the display 200 may be used as an input device that is provided with a touch screen function while being used as an output device that outputs a screen. The display panel 200c may include a display element layer including one or more pixels and a TFT layer connected to the display element layer. According to various embodiments, the display panel 200c may correspond to a panel such as a liquid crystal display (LCD), a light-emitting diode (LED), or an organic light-emitting diode (OLED), and may display various images according to various operation states, application execution, content, or the like of the electronic device 101.

According to various embodiments, as the touch panel 200d, various types of touch panels may be included. For example, various touch panels, such as a capacitive touch panel that detects a change in capacitance, a pressure-sensitive touch panel that detects a position by detecting a pressure acting on the panel, an optical touch panel using infrared rays, and a transparent electrode-type touch panel using contacts of a transparent conductive film, may be used. In addition, various types of input position detection panels not mentioned above, such as an electromagnetic resonance type touch panel, may be used.

According to various embodiments, the window member 200a may serve as a protective film for protecting the display panel 200c. As a protective film, the window member 200a may be made of a material that protects the display panel 200c from external impacts, is resistant to scratches, and generates fewer wrinkles in the folding area even when the foldable housing is repeatedly folded and unfolded. For example, as the material of the window member 200a, a clear polyimide (CPI) film or ultra-thin glass (UTG) may be included.

FIG. 4 is an exploded perspective view illustrating an electronic device 400 (e.g., the electronic device 101 in FIG. 1) according to various embodiments.

Referring to FIG. 4, in various embodiments, the electronic device 400 may include a display 410 (e.g., the display 200 in FIG. 2), a foldable housing 420 (e.g., the foldable housing 300 in FIG. 2), a printed circuit board 430, a hinge structure 440, a flexible connecting member 450, a hinge cover 460, an antenna module 470, and a rear cover 480. Hereinafter, a detailed description of components those described with reference to FIGS. 2, 3A and 3B (e.g., the display 410, the foldable housing 420, and the rear cover 480) will be omitted.

According to various embodiments, the display 410 may be exposed through a substantial portion of a front plate 411. In some embodiments, the shape of the display 410 may be substantially the same as the shape of the periphery of the front plate 411.

According to various embodiments, the foldable housing 420 may include a first housing 421 and a second housing 422. According to an embodiment, the first housing 421 may include a first surface 421a and a second surface 421b facing away from the first surface 421a, and the second housing 422 may include a third surface 422a and a fourth surface 422b facing away from the third surface 422a. The foldable housing 420 may additionally or alternatively include a bracket assembly. The bracket assembly may include a first bracket assembly 423 disposed in the first housing 421 and a second bracket assembly 424 disposed in the second housing 422. At least a portion of the bracket assembly, for example, a portion 425 including at least a portion of the first bracket assembly 423 and at least a portion of the second bracket assembly 424, may serve as a plate for supporting the hinge structure 440.

According to various embodiments, various electric elements may be disposed on the printed circuit board 430. For example, a processor (e.g., the processor 120 in FIG. 1), a memory (e.g., the memory 130 in FIG. 1), and/or an interface (e.g., the interface 177 in FIG. 1) may be mounted on the printed circuit board 430. The processor may include at least one of, for example, a central processing unit, an application processor, a graphics processing unit, an image signal processor, a sensor hub processor, or a communication processor. The memory may include, for example, a volatile memory or a non-volatile memory. The interface may include, for example, a high-definition multimedia interface (HDMI), a universal serial bus (USB) interface, an SD card interface, and/or an audio interface. The interface may electrically or physically connect, for example, the electronic device 300 to an external electronic device, and may include a USB connector, an SD card/an MMC connector, or an audio connector.

According to various embodiments, the printed circuit board 430 may include a first printed circuit board 431 disposed on the first bracket assembly 423 side and a second printed circuit board 432 disposed on the second bracket assembly 424 side. The first printed circuit board 431 and the second printed circuit board 432 may be disposed inside the space defined by the foldable housing 420, the bracket assemblies 423 and 424, the first rear cover 481, and/or the second rear cover 482. Components for implementing various functions of the electronic device 400 may be mounted on the first printed circuit board 431 and the second printed circuit board 432 to be separated from each other. For example, a processor may be disposed on the first printed circuit board 431, and an audio interface may be disposed on the second printed circuit board 432.

According to various embodiments, a battery may be disposed adjacent to the printed circuit board 430 so as to supply power to the electronic device 400. At least a portion of the battery may be disposed on substantially the same plane as, for example, the printed circuit board 430. According to an embodiment, a first battery 433 may be disposed adjacent to the first printed circuit board 431, and a second battery 434 may be disposed adjacent to the second printed circuit board 432. The battery is a device for supplying power to at least one component of the electronic device 400, and may include, for example, a non-rechargeable primary battery, a rechargeable secondary battery, or a fuel cell. The battery may be integrally disposed inside the electronic device 400, or may be disposed to be detachable/attachable from/to the electronic device 400. According to various embodiments, the hinge structure 440 may be configured to support the foldable housing 420 and/or the bracket assemblies 423 and 424 such that the foldable housing 420 is rotatable about a folding axis (e.g., A-A' in FIG. 2). The hinge structure 440 may include a first hinge structure 441 disposed on the first printed circuit board 431 side and a second hinge structure 442 disposed on the second printed circuit board 432 side. The hinge structure 440 may be disposed between the first printed circuit board 431 and the second printed circuit board 432. According to an embodiment, the hinge structure 440 may be configured substantially integrally with a portion 425 including at least a portion of the first bracket assembly 423 and at least a portion of the second bracket assembly 424.

According to various embodiments, the "housing structure" may be a structure that includes a foldable housing 420, and one or more components disposed inside the foldable housing 420 may be assembled and/or combined with each other. The housing structure may include a first housing structure and a second housing structure. For example, an assembled configuration that includes the first housing 421 and further includes at least one of the first bracket assembly 423, the first printed circuit board 431, and the first battery 433 disposed inside the first housing 421 may be referred to as a "first housing structure". As another example, an assembled configuration that includes the second housing 422 and further includes at least one of the second bracket assembly 424, the second printed circuit board 432, and the second battery 434 disposed inside the second housing 422 may be referred to as a "second housing structure". However, it should be noted that the "first housing structure" and the "second housing structure" are not limited to the addition of the above-described components, and various other components may be additionally included or omitted.

According to various embodiments, the flexible connecting member 450 is, for example, a flexible printed circuit board (FPCB), and may connect various electrical components disposed on the first printed circuit board 431 and the second printed circuit board 432. To this end, the flexible connecting member 450 may be disposed across the "first housing structure" and the "second housing structure". According to an embodiment, the flexible connecting member 450 may be disposed such that at least a portion thereof extends across the hinge structure 440. According to an embodiment, the flexible connecting member 450 may be configured to connect the first printed circuit board 431 and the second printed circuit board 432 to each other across, for example, the hinge structure 440 in a direction parallel to the Y axis of FIG. 4. As another example, the flexible connecting member 450 may be fitted and coupled to the openings 441h and 442h provided in the hinge structure 440. In this case, a portion 450a of the flexible connecting member 450 may be disposed to extend across one side (e.g., the upper portion) of the first hinge structure 441, and the other portion 450b of the flexible connecting member 450 may be disposed to extend across one side (e.g., the upper portion) of the second hinge structure 442. In addition, still another portion 450c of the flexible connecting member 450 may be disposed on the other sides (e.g., the lower portions) of the first hinge structure 441 and the second hinge structure 442. At positions adjacent to the first hinge structure 441 and the second hinge structure 442, a space (hereinafter, referred to as a "hinge space") surrounded by at least a portion of the first hinge structure 441, at least a portion of the second hinge structure 442, and at least a portion of the hinge cover 460 may be provided. According to an embodiment, at least a portion 450c of the flexible connecting member 450 may be disposed in the hinge space.

According to various embodiments, the hinge cover 460 may be configured to enclose at least a portion of the hinge space. The hinge cover 460 may close the hinge space together with the hinge structure 440, and may protect the components (e.g., at least a portion 450c of the flexible connecting member 450) disposed inside the hinge space from an external impact. According to an embodiment, the hinge cover 460 may be disposed between the first housing 421 and the second housing 422. According to an embodiment, the hinge cover 460 may be coupled to each of at least a portion of the first housing and at least a portion of the second housing.

According to various embodiments, the antenna module 470 (e.g., the antenna module 197 of FIG. 1) may be disposed between the rear cover 480 and the battery. The antenna module 470 may include a plurality of antenna modules in a single electronic device 400. For example, the antenna module 470 may include a first antenna module 471 disposed on the first housing 421 side and a second antenna module 472 disposed on the second housing 422 side. The antenna module may include at least one radiator. In addition, the antenna module 470 may include, for example, a near-field communication (NFC) antenna, a wireless charging antenna, and/or a magnetic secure transmission (MST) antenna. The antenna module 470 may perform short-range communication with, for example, an external electronic device, or may transmit/receive power required for charging to/from the external device in a wireless manner. In another embodiment, an antenna structure may be provided by a portion of a side bezel structure of the foldable housing 420, a portion of a bracket assembly, or a combination thereof.

According to various embodiments, the rear cover 480 may include a first rear cover 481 and a second rear cover 482. The rear cover 480 may be coupled to the foldable housing 420 to protect the above-described components (e.g., the printed circuit board 430, the battery, the flexible connecting member 450, and the antenna module 470) disposed inside the foldable housing 420. As described above, the rear cover 480 may be configured substantially integrally with the foldable housing 420.

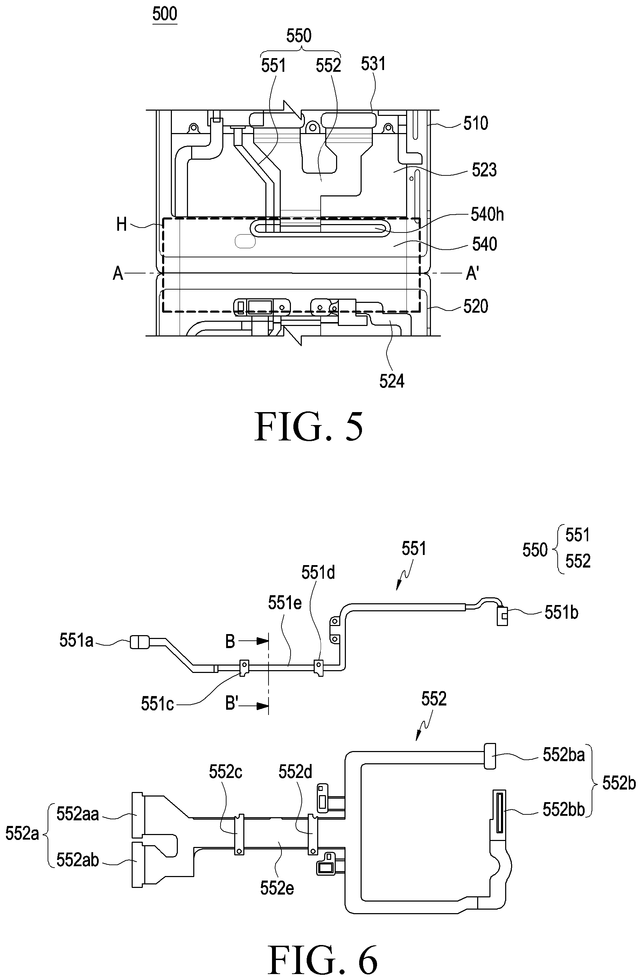

FIG. 5 is a view 500 illustrating a portion of the inside of an electronic device (e.g., the electronic device 400 in FIG. 4) according to various embodiments.

Referring to FIG. 5, the foldable housing 501 (e.g., the foldable housing 420 in FIG. 4) may include a first housing 510 and a second housing 520. Here, the first housing 510 (e.g., the first housing 421 in FIG. 4) and the second housing 520 (e.g., the second housing 422 in FIG. 4) may be cover portions that enclose a first housing structure (e.g., the first housing structure 310 in FIG. 2) and a second housing structure (e.g., the second housing structure 320 in FIG. 2), respectively.

Referring to FIG. 5, the flexible connecting member 550 may lie across at least a portion of the inside of the first housing structure (e.g., the first housing structure 310 in FIG. 2) and at least a portion of the inside of the second housing structure (e.g., the second housing structure 320 in FIG. 2). Here, the description "the flexible connecting member 550 lies across the inside of a housing structure" may mean that the flexible connecting member 550 having a relatively long elongated shape is disposed above or below the housing structure (or the components inside the housing structure). As described above, the housing structure may have a configuration including a housing and additionally including at least one of a bracket assembly, a printed circuit board, and a battery, which are disposed inside the housing and assembled. Accordingly, the description "the flexible connecting member 550 lies across at least a portion of the inside of the housing structure" may be interpreted similarly to the description "the flexible connecting member lies across at least some of the components included in the housing structure". For example, the flexible connecting member 550 may lie across at least a portion of a first bracket assembly 523 (e.g., the first bracket assembly 423 in FIG. 4) and at least a portion of a second bracket assembly 524 (e.g., the second bracket assembly 424 in FIG. 4).

As illustrated in FIG. 5, when viewing the inside of the foldable housing 501 from above, at least a portion of the flexible connecting member 550 may be covered by the hinge structure 540. The portion H covered by the hinge structure 540 may be a portion disposed in the hinge space. In addition, the portion H covered by the hinge structure 540 may be a portion in which movement (or bending) occurs repeatedly in the flexible connecting member 550 during the unfolding and folding operations of the foldable electronic device, that is, a bending portion. In the bending portion of the flexible connecting member 550, stresses caused due to friction with housings, components, or other substrates may be accumulated.

According to various embodiments, the flexible connecting member 550 included in the foldable electronic device may include one or more flexible connecting members 551 and 552. According to an embodiment, at least a portion of the flexible connecting member 550 may lie across the inside of the first housing structure including the first housing 510, the first bracket assembly 523, and the first printed circuit board 531, and another portion may lie across the inside of the second housing structure including the second housing 520 and the second bracket assembly 524. For reference, the second printed circuit board may be omitted in FIG. 5. The flexible connecting member 550 may lie on the first housing structure and the second housing structure across the hinge structure 540. In this case, a portion of the flexible connecting member 550 may be configured to pass through an opening 540h provided in the hinge structure 540.

FIG. 6 is a view illustrating the flexible connecting member 550 according to various embodiments of the disclosure.

Referring to FIG. 6, according to various embodiments of the disclosure, the flexible connecting member 550 may include one or more flexible connecting members. For example, the flexible connecting member 550 may include a first flexible connecting member 551 and a second flexible connecting member 552. Although not illustrated in the drawings, the flexible connecting member 550 may further include a third flexible connecting member (not illustrated) or other flexible connecting members.

The flexible connecting member 550, the first flexible connecting member 551, and the second flexible connecting member 552 illustrated in FIG. 6 may be respectively the same as or similar to the flexible connecting member 550, the first flexible connecting member 551, and the second flexible connecting member 552 illustrated in FIG. 5. Accordingly, descriptions of the same components may be omitted.

In the embodiment of FIG. 6, the first flexible connecting member 551 and the second flexible connecting member 552 may be illustrated as two flexible connecting members that are completely separated and distinguished from each other.

As another example, unlike this, substantially one flexible connecting member may be divided into a first flexible connecting member 551 and a second flexible connecting member 552. For example, substantially one flexible connecting member, which is not physically divided, may be divided into a first flexible connecting member 551 and a second flexible connecting member 552 according to the types of signal lines, and may be branched into two or more branches in only some of the areas in which the flexible connecting members are located. For example, although not illustrated in the drawings, the first flexible connecting member 551 and the second flexible connecting member 552 may have a form of an integrated flexible connecting member inside the first housing structure (e.g., the first housing structure 310 in FIG. 2), and may be branched into two different flexible connecting members 551 and 552 inside the second housing structure (e.g., the second housing structure 320 in FIG. 2). As described above, it should be noted that the shape of the flexible connecting members may be variously set for each embodiment. In the following description, for convenience of description, a case in which two flexible connecting members 551 and 552, which are physically spaced apart from each other and have different shapes, will be mainly described, but it should be noted that the scope of the disclosure is not necessarily limited thereto.

Referring to FIG. 6 again, the first flexible connecting member 551 may lie across at least a portion of the inside of the first housing structure (e.g., the first housing structure 310 in FIG. 2) and at least a portion of the second housing structure (e.g., the second housing structure 320 in FIG. 2). The second flexible connecting member 552 may also lie across at least a portion of the first housing structure (e.g., the first housing structure 310 in FIG. 2) and at least a portion of the second housing structure (e.g., the second housing structure 320 in FIG. 2).

According to various embodiments, each of the first and second flexible connecting members 551 and 552 may include a means to be connected to at least one of a first printed circuit board (e.g., the first printed circuit board 431 in FIG. 4) or a second printed circuit board (e.g., the second printed circuit board 432 in FIG. 4). According to an embodiment, the first flexible connecting member 551 may electrically connect the first printed circuit board (e.g., the first printed circuit board 431 in FIG. 4) and the second printed circuit board (e.g., the second printed circuit board 432 in FIG. 4) to each other via connecting end portions 551a and 551b disposed at the opposite ends thereof. According to an embodiment, the second flexible connecting member 552 may also electrically connect the first printed circuit board (e.g., the first printed circuit board 431 in FIG. 4) and the second printed circuit board (e.g., the second printed circuit board 432 in FIG. 4) to each other via connecting end portions 552a and 552b disposed at the opposite ends thereof. According to an embodiment, the connecting end portion 552a may include a first connecting end portion 552aa and a second connecting end portion 552ab, and the connecting end portion 552b may include a third connecting end portion 552ba and a fourth connecting end portion 552bb. According to an embodiment, the first printed circuit board 431 and the second printed circuit board 432 may be electrically connected to each other via the first to fourth connecting end portions 552aa, 552ab, 552ba, and 552bb. Here, the connecting end portions may each include a receptacle or a header in which at least one pin is provided. The first and second flexible connecting members 551 and 552 may be connected to at least one of the first printed circuit board and the second printed circuit board via various other means as well as the receptacle or header structure. For example, the flexible connecting members 551 and 552 may be connected to at least one of the first printed circuit board (e.g., the first printed circuit board 431 in FIG. 4) or the second printed circuit board (e.g., the second printed circuit board 432 in FIG. 4) via a bonding part formed through a hot-bar process using thermocompression. The shapes of the connecting end portions and the manufacturing method therefor are not limited to any specific embodiment. According to various embodiments, depending on the shapes of the connecting end portions, the first and second flexible connecting members 551 and 552 may include, for example, a flexible printed circuit (FPC) or a flexible flat cable (FFC) type connector structure, a board to board (B to B) type connector structure, a zip type connector structure, a bonding type connector structure formed through a hot-bar process, a low insertion force (LIF) connector structure, or a zero insertion force (ZIF) connector structure.

The first flexible connecting member 551 may include, along the longitudinal direction of the first flexible connecting member 551, a rigid portion 551c fixed to the side of the first housing structure (e.g., the first housing structure 310 in FIG. 4), a rigid portion 551d fixed to the side of the second housing structure (e.g., the second housing structure 320 in FIG. 4), and a flex portion 551e disposed between the rigid portions 551c and 551d. The second flexible connecting member 552 may include, along the longitudinal direction of the flexible connecting member 551, a rigid portion 552c fixed to the side of the first housing structure (e.g., the first housing structure 310 in FIG. 4), a rigid portion 552d fixed to the side of the second housing structure (e.g., the second housing structure 320 in FIG. 4), and a flex portion 552e disposed between the rigid portions 552c and 552d. Here, the description "the rigid portions 551c and 551d of the first flexible connecting member 551 are fixed to the side of the first housing structure and the side of the second housing structure" may include, for example, the case in which the rigid portion 551c of the first flexible connecting member 551 is fixed to the first hinge structure (e.g., the first hinge structure 441 in FIG. 4), the first printed circuit board (e.g., the first printed circuit board 431 in FIG. 4), or the first bracket assembly (e.g., the first bracket assembly 423 in FIG. 4) disposed inside the first housing structure 310. Like this, the description may include the case in which the rigid portion 551d of the first flexible connecting member 551 is fixed to the second hinge structure (e.g., the second hinge structure 442 in FIG. 4), the second printed circuit board (e.g., the second circuit board 432 in FIG. 4), or the second bracket assembly (e.g., the second bracket assembly 424 in FIG. 4) disposed inside the second housing structure 320. According to an embodiment, the description "the rigid portions 552c and 552d of the second flexible connecting member 552 are fixed to the side of the first housing structure side and the side of the second housing structure" may be similarly applicable to an embodiment in which the rigid portions 551c and 551d of the first flexible connecting member 551 are fixed to the first housing structure side and the second housing structure side.

According to various embodiments, the first and second flexible connecting members 551 and 552 may provide at least one electrically conductive path connecting the first printed circuit board (e.g., the first printed circuit board 431 in FIG. 4) and the second printed circuit board (e.g., the first printed circuit board 432 in FIG. 4) to each other. Power or a control signal provided from the power management module or the processor may be transmitted to an internal component of the electronic device 101 through the electrically conductive path. As another example, the flexible connecting members 551 and 552 may each include an RF wire, which is a high-frequency signal line, as an electrically conductive path for transmitting a communication signal provided from an RF transceiver or a communication signal received via a communication device to another RF transceiver. For example, the first flexible connecting member 551 may include a wire (or an electrically conductive path) for transmitting a communication signal including an RF signal. In addition, the second flexible connecting member 552 may include a wire for transmitting an electrical signal, which is less sensitive to an impedance change than a wire included in the first flexible connecting member 551. For example, the second flexible connecting member 552 may include a power wire. According to another embodiment, the second flexible connecting member 552 may include a wire for transmitting data and/or a wire for transmitting a control signal (an electrically conductive path) in addition to or instead of the power wire. According to an embodiment, the first flexible connecting member 551 may be thinner and narrower than the second flexible connecting member 552 depending on RF signal characteristics. Therefore, when the first flexible connecting member 551 including an electrically conductive path for transmitting an RF signal is repeatedly used within the hinge space, the durability thereof will be relatively weak compared to the second flexible connecting member 552, and it may be difficult to exhibit smooth communication performance because the first flexible connecting member 551 is vulnerable to a change in impedance. When the first flexible connecting member 551 is used as a wire for transmitting a communication signal including an RF signal, in order to minimize the impedance change in the highly bendable section (e.g., the flex portions 551e and 552e), adjusting the width or thickness thereof may also be limited. According to an embodiment, the highly bendable section may refer to the flex portions 551e and 552e. For example, the flex portions 551e and 552e may be bent or flat depending on the use state of the electronic device 101.

As a result, according to various embodiments of the disclosure, at least one end 551a or 551b of the first flexible connecting member 551 may additionally include an impedance matching unit (not illustrated). Here, the at least one end 551a or 551b of the flexible connecting member 550 may correspond to a rigid portion of the flexible connecting member.

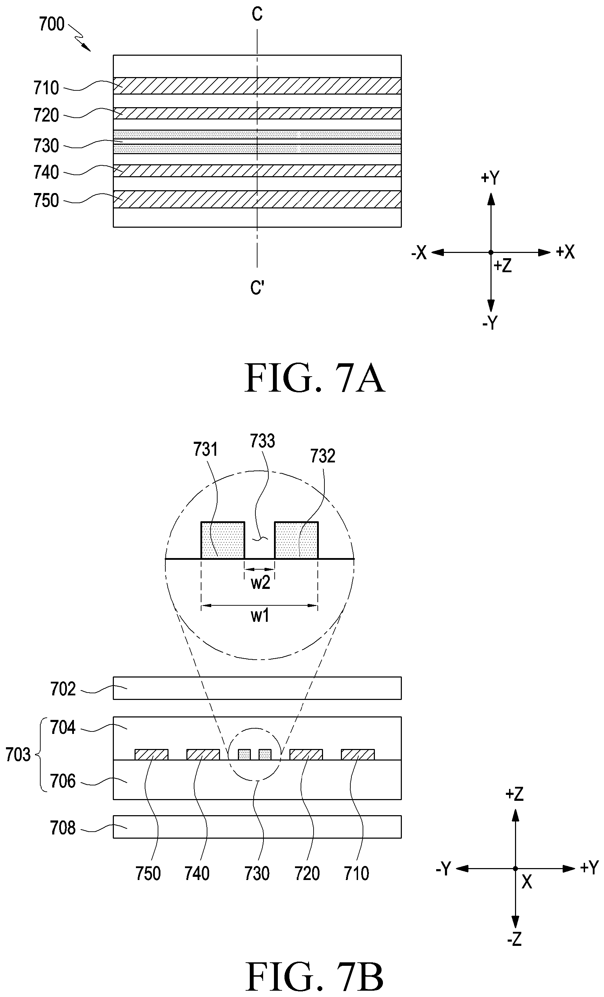

Hereinafter, in describing the flexible connecting member 550, the first flexible connecting member 551, which is provided with a wire for transmitting a communication signal including an RF signal, will be mainly described. For convenience of description, a flexible connecting member (e.g., the flexible connecting member 700 in FIGS. 7A and 7B) in the following description may mean a CPW wiring structure.

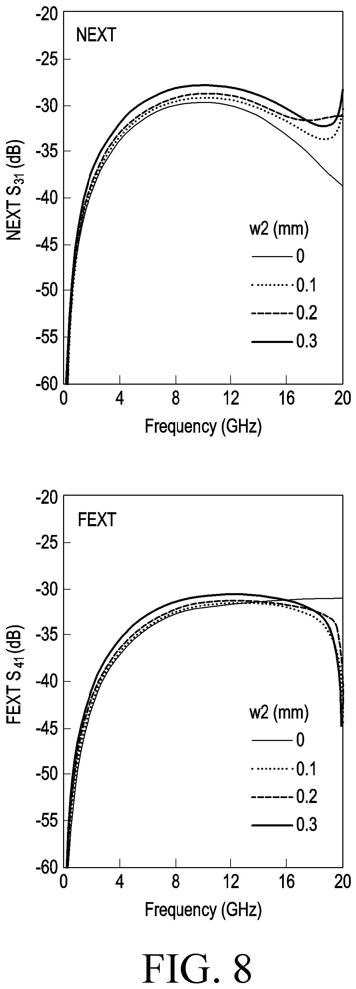

FIGS. 7A and 7B illustrate an implemented example of the flexible connecting member according to the first embodiment, which is not covered by the claims. FIG. 7A is a top view illustrating the flexible connecting member according to the first embodiment viewed in parallel to the X axis. FIG. 7B is a view illustrating a cross section taken along line C-C' in FIG. 7A. FIG. 8 is a view showing an S-parameter of the flexible connecting member according to the first embodiment.

Referring to FIGS. 7A and 7B, the flexible connecting member 700 may include a plurality of stacked structures. For example, the flexible connecting member 700 may include a first protective layer 702, a wiring layer 703 disposed under the first protective layer 702, and a second protective layer 708 disposed under the wiring layer 703. The wiring layer 703 may include a support layer 706 configured to support a plurality of wiring lines and ground lines and a dielectric layer 704 covering the support layer 706. In an embodiment, the first protective layer 702 and the dielectric layer 704 may be spaced apart from each other by a predetermined distance, and the support layer 706 and the second protective layer 708 may be spaced apart from each other by a predetermined distance.

According to various embodiments, the flexible connecting member 700 may include a plurality of signal wires 720 and 740. For example, although two signal wires (e.g., the first signal wire 720 and the second signal wire 740) are illustrated, it will be understood that the number of signal wires may vary.

According to various embodiments, the flexible connecting member 700 may include a plurality of ground wires 710, 730, and 750 disposed adjacent to the plurality of signal wires 720 and 740. For example, although three ground wires (e.g., the first ground wire 710, the second ground wire 730, and the third ground wire 750) are illustrated, the number of ground wires may also vary.

According to various embodiments, when viewed in a direction parallel to the X axis, the first ground wire 710 and the third ground wire 750 may be disposed on both sides (in the Z-axis direction) edges of the flexible connecting member 700. In an embodiment, a first signal wire 720 and a second signal wire 740 may be disposed between the first ground wire 710 and the third ground wire 750.

According to various embodiments, the second ground wire 730 may be disposed between the first signal wire 720 and the second signal wire 740. In addition, the second ground wire 730 may be provided as a common ground for preventing crosstalk between the first signal wire 720 and the second signal wire 740. In other words, the second ground wire 730 may be referred to as a common ground wire 730 disposed between the first signal wire 720 and the second signal wire 740.

According to various embodiments, the second ground wire 730 may include a gap 733. According to an embodiment, the second ground wire 730 may be configured to be divided based on the gap 733. In other words, the second ground wire 730 may include a first divided wire 731 and a second divided wire 732 which are divided by the gap 733.

According to various embodiments, the width W2 of the gap 733 may be determined in consideration of a signal transmission characteristic or crosstalk reduction performance of the flexible connecting member 700. In addition, the width W2 of the gap 733 and the width W1 of the common ground wire 730 may have a predetermined ratio. For example, the ratio between the width W2 of the gap 733 and the width W1 of the common ground wire 730 may be 1:2. In some embodiments, the width W2 of the gap 733 may have a length of 30% to 50% of the width W1 of the common ground wire 730. As another example, the width W2 of the gap 733, the width of the first divided wire 731 in the length direction (the Y-axis direction), and the width of the second divided wire 732 in the length direction (the Y-axis direction) may correspond to each other in terms of length ratio. For example, the length ratio may be 1:1:1. Since the width W2 of the gap 733 and the widths of the first and second divided wires 731 in the length direction (the Y-axis direction) correspond to each other, the efficiency of a manufacturing process may be improved.

According to various embodiments (see FIG. 8), the scattering parameter (S-parameter) of the flexible connecting member 700 may be changed depending on the width W2 of the gap 733. In the embodiment illustrated in FIG. 8, a 3-dimensional electromagnetic field simulation for obtaining an S-parameter was carried out in which the first signal wire 720 was regarded as an aggressor and the second signal wire 740 was regarded as a victim. In addition, near-end crosstalk (NEXT) and far-end crosstalk (FEXT) were derived from the above-mentioned S-parameter. In addition, the width W1 of the common ground wire 730 was set to 1 millimeter.

According to various embodiments, compared to the case where the width W2 of the gap 733 was 0 (i.e., the gap 733 was not formed), even in the case the width W2 of the gap 733 was increased by 0.3 mm (that is, when W2 increased to approximately 30% of W1), the change in NEXT and FEXT performances were not significant. In contrast, when the width W2 of the gap 733 was increased, it the amount of the metal material included in the second ground wire 730 was able to be reduced, and durability of the flexible connecting member 700 against bending was able to increase. In other words, it may be expressed that by providing the gap 733 in the second ground wire 730, it is possible to ensure stable signal performance while reducing the metal density of the flexible connecting member 700.

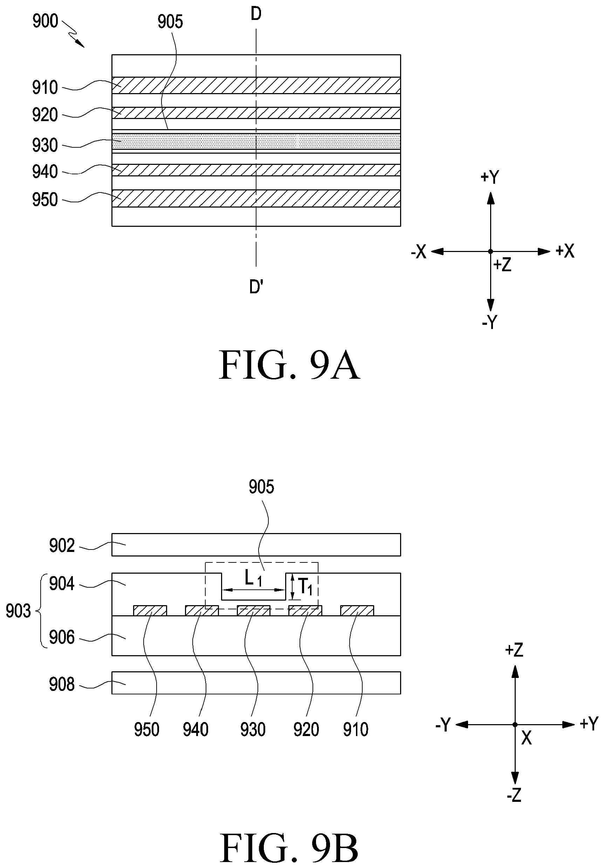

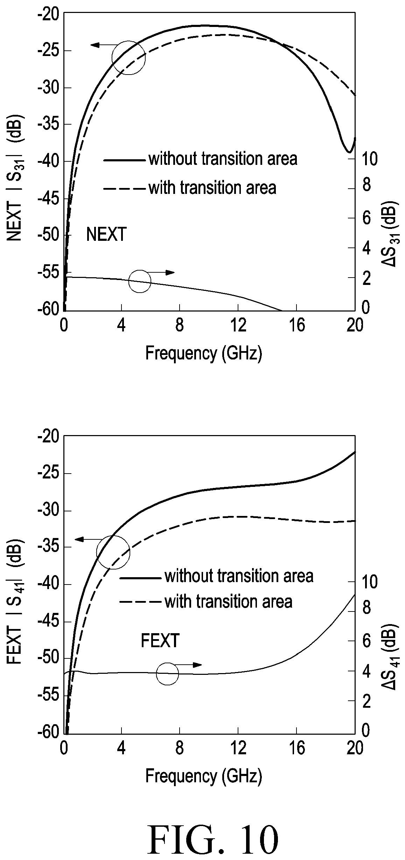

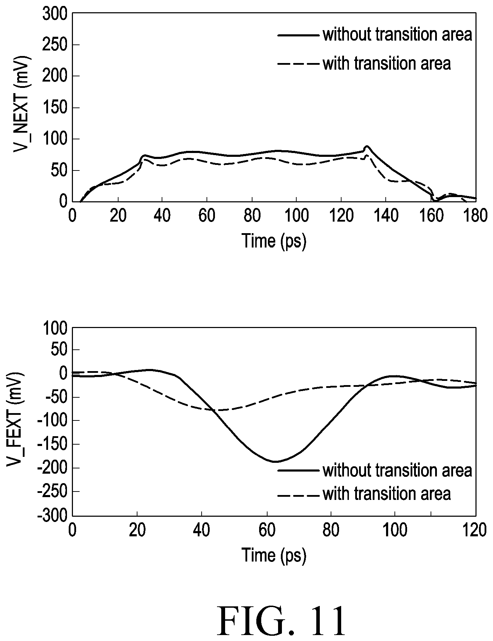

FIGS. 9A and 9B illustrate an implemented example of the flexible connecting member according to a second embodiment, which is an embodiment of the claimed invention. FIG. 9A is a top view illustrating the flexible connecting member according to the second embodiment viewed in parallel to the X axis. FIG. 9B is a view illustrating a cross section taken along line D-D' in FIG. 9A. FIG. 10 is a view illustrating NEXT and FEXT test results of the flexible connecting member according to the second embodiment. FIG. 11 is a view illustrating crosstalk performance of the flexible connecting member according to the second embodiment in a time domain.

Referring to FIGS. 9A and 9B, the flexible connecting member 900 may include a plurality of stacked structures. The flexible connecting member 900 includes a first protective layer 902, a wiring layer 903 disposed under the first protective layer 902, and a second protective layer 908 disposed under the wiring layer 903. The wiring layer 903 includes a support layer 906 configured to support a plurality of wires, in particular wiring lines and ground lines, and a dielectric layer 904 covering the support layer 906. On the support layer 906, a first ground wire 910, a second ground wire 930, a third ground wire 950, a first signal wire 920, and a second signal wire 940 are disposed. Herein, the second ground wire 930 may be understood to form a common ground wire. Since the arrangement structure of the flexible connecting member 900 of FIGS. 9A and 9B is similar to the arrangement structure of the flexible connecting member 700 of FIGS. 7A and 7B, redundant descriptions will be omitted.

According to various embodiments, the flexible connecting member 900 includes a permittivity change area 905. According to an embodiment, the permittivity change area 905 may be provided in at least a partial area of the dielectric layer 904. For example, the permittivity change area 905 may mean an area having a permittivity different from that of the peripheral area, preferably a permittivity different from that of the surrounding dielectric layer 904. Thus, in other words, the permittivity change area 905 may mean an area where there is a change in permittivity compared to the peripheral area, preferably compared to the surrounding dielectric layer 904. In an embodiment, the permittivity change area 905 may be provided at a predetermined position. For example, the permittivity change area 905 may be provided in a partial area of the dielectric layer 904 corresponding to the second ground wire 930 (or a common ground wire). The permittivity change area 905 may be provided above (in the +Z-axis direction) of the second ground wire 930 from a point of view of stacking (when viewed in parallel to the X axis). According to the invention as claimed, the permittivity change area 905 is provided to overlap the second ground wire 930, preferably when viewed from above (when viewed in a direction in parallel to the Z axis). In some embodiments, which are merely optional, the permittivity change area 905 may be provided to overlap at least a portion of the first signal wire 920 and/or the second signal wire 940 when viewed from above (when viewed in parallel to the Z axis).

By providing the permittivity change area 905, it is possible to reduce crosstalk between the signal wires 920, 940 thanks to the different permittivity with respect to the surrounding material while maintaining a sufficient durability of the flexible connecting member 900 against bending.

According to various embodiments, the permittivity change area 905 may have a first width L1 and a first depth T1. In an embodiment, the first width L1 and the first depth T1 of the permittivity change area 905 may be determined in consideration of a signal transmission characteristic or crosstalk reduction performance of the flexible connecting member 900. For example, the length of the first width L1 may be smaller than the distance from an area of one edge (e.g., the edge in the -Y-axis direction) of the first signal wire 920 to one edge (e.g., the edge in the +Y-axis direction) of the second signal wire 940, and greater than the width of the second ground wire 930 in the length direction (the Y-axis direction). In other words, the first width L1 may be smaller than a minimum width between the first signal wire 920 and the second signal wire 940. As another example, the length of the first width L1 may be smaller than the distance from an area of the other edge (e.g., the edge in the +Y-axis direction) of the first signal wire 920 to the other edge (e.g., the edge in the -Y-axis direction) of the second signal wire 940, and greater than the width of the second ground wire 930 in the length direction (the Y-axis direction). In other words, the first width L1 may be smaller than a maximum width between the first signal wire 920 and the second signal wire 940. As another example, the length of the first width L1 may correspond to or be slightly smaller than the width of the second ground wire 930 in the length direction (the Y-axis direction). All of these embodiments are merely optional and do not constitute essential features but promote the technical advantages of the claimed invention. In particular, these embodiments allow for crosstalk to be effectively reduced between the signal wires 920, 940 with low production effort. Also, by removing a partial area of the dielectric layer 904 (i.e. by reducing the density of the dielectric layer 904), the durability of the flexible connecting member 900 against bending may be increased.

According to various embodiments, the first depth T1 may be determined in consideration of the thickness of the dielectric layer 904 and the thickness of the common ground wire 930 (and/or other wires). For example, the first depth T1 may be about 30% or more to less than 100% of the remaining thickness obtained by excluding the thickness of the ground wire 930 from the total thickness of the dielectric layer 940. However, 30% is only a numerical example and various implementation modifications are possible. As a result, while the permittivity is changed (reduced) by removing a partial area of the dielectric layer 904, the ground wire 930 is capable of being protected without being exposed to the outside. In other words, the first depth T1 may be provided to a depth at which the common ground wire 930 or the first and second signal wires 920 and 940 are not exposed by the permittivity change area 905. For example, the first depth T1 may be about 30% to about 90% of the remaining thickness, preferably about 40% to about 90% of the remaining thickness. Such values for the first depth T1 allow for a sufficient reduction of crosstalk between the signal wires 920, 940 while still covering the second ground wire 930.

According to various embodiments, the permittivity change area 905 may have a permittivity different from that of the material of the dielectric layer 904 around the permittivity change area 905. For example, the permittivity of the permittivity change area 905 may have a permittivity smaller than that of the peripheral dielectric layer 904. In an embodiment, a material different from that of the peripheral dielectric layer 904 may be disposed in the permittivity change area 905. For example, the material disposed in the permittivity change area 905 may have a permittivity lower than that of the material of the dielectric layer 904. For example, the permittivity change area 905 may be filled with air. By providing the permittivity change area 905 with a permittivity different, in particular smaller, than that of the peripheral dielectric layer 904, reduction of crosstalk between the signal wires 920, 940 may be effectively achieved.

According to various embodiments (see FIG. 10), the scattering parameter (S-parameter) of the flexible connecting member 900 may be changed depending on whether the permittivity change area 905 is provided. In the embodiment illustrated in FIG. 10, a 3-dimensional electromagnetic field simulation for obtaining an S-parameter was carried out in which the first signal wire 920 was regarded as an aggressor and the second signal wire 940 was regarded as a victim. In addition, near-end crosstalk (NEXT) and far-end crosstalk (FEXT) were derived from the above-mentioned S-parameter.

According to various embodiments, it can be seen that when the permittivity change area 905 is provided, NEXT and FEXT performances are improved compared to the case where the permittivity change area 905 is not provided. For example, in the NEXT test result, it was found that the crosstalk performance was improved in the frequency band of 0.01 GHz to 14.7 GHz, and the crosstalk was reduced by up to 2.1 dB in the low frequency band. In addition, in the FEXT test result, it was found that the crosstalk performance was improved from 0.01 GHz to 20 GHz, and in particular, the crosstalk was reduced by 4.02 dB in the low frequency band.

FIG. 11 shows test results of time domain simulation. The NEXT and FEXT test results of FIG. 11 were obtained by applying a step signal to the first signal wire 920 (the aggressor).

According to various embodiments, as illustrated in the drawing, the maximum peak voltage obtained when the permittivity change area 905 was provided was reduced compared to that obtained when the permittivity change area 905 was not provided. For example, in the NEXT test result, when the permittivity change area 905 was provided, the maximum peak voltage was reduced by about 11.8 mV compared to that in the case where the permittivity change area 905 was not provided. In addition, in the FEXT test result, when the permittivity change area 905 was provided, the maximum peak voltage was reduced by about 109.4 mV compared to that in the case where the permittivity change area 905 was not provided.

Therefore, by providing the permittivity change area 905, it is possible to provide the crosstalk improvement effect of the flexible connecting member 900 and that, by removing a partial area of the dielectric layer 904 (by reducing the density of the dielectric layer 904), it is possible to increase durability of the flexible connecting member 700 against bending.

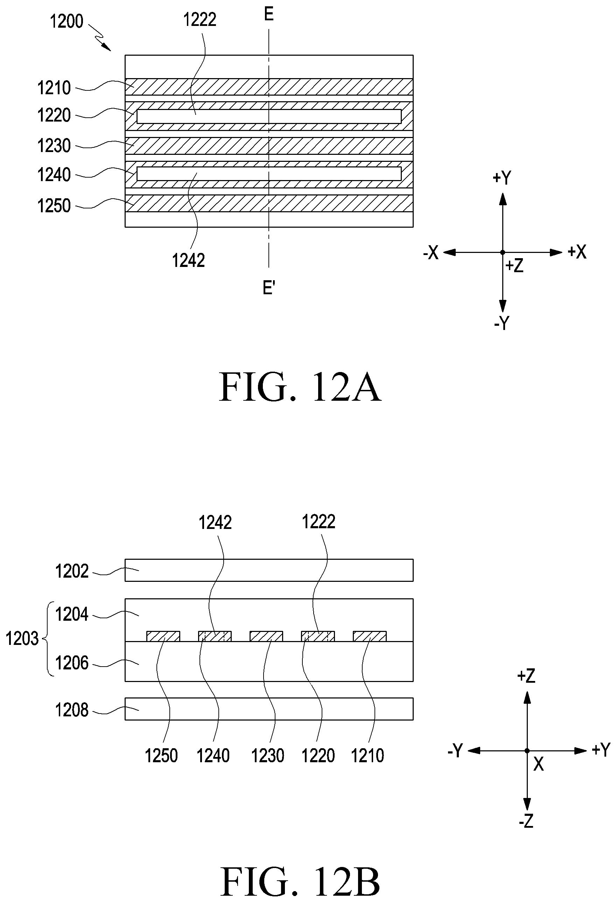

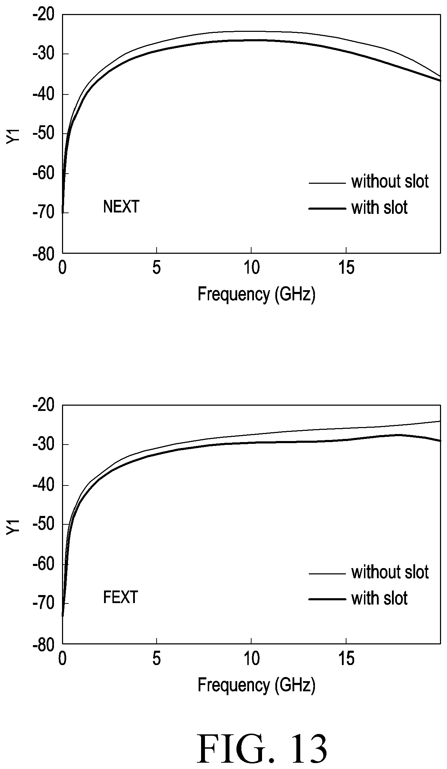

FIGS. 12A and 12B illustrate an implemented example of the flexible connecting member according to a third embodiment, which is not covered by the claims. FIG. 12A is a top view illustrating the flexible connecting member according to the third embodiment viewed in parallel to the X axis. FIG. 12B is a view illustrating a cross section taken along line E-E' in FIG. 12A. FIG. 13 is a view illustrating NEXT and FEXT test results of the flexible connecting member according to the third embodiment.

Referring to FIGS. 12A and 12B, the flexible connecting member 1200 may include a plurality of stacked structures. For example, the flexible connecting member 1200 may include a first protective layer 1202, a wiring layer 1203 disposed under the first protective layer 1202, and a second protective layer 1208 disposed under the wiring layer 1203. The wiring layer 1203 may include a support layer 1206 configured to support a plurality of wiring lines and ground lines and a dielectric layer 1204 covering the support layer 1206. On the support layer 1206, a first ground wire 1210, a second ground wire 1230, a third ground wire 1250, a first signal wire 1220, and a second signal wire 1240 may be disposed. Since the arrangement structure of the flexible connecting member 1200 of FIGS. 12A and 12B is similar to the arrangement structure of the flexible connecting member 700 of FIGS. 7A and 7B and/or the flexible connecting structure 900 of FIGS. 9A and 9B, redundant descriptions will be omitted.

According to various embodiments, the flexible connecting member 1200 may include slots 1222 and 1242 provided in all or some of the signal wires (e.g., the first signal wire 1220 and/or the second signal wire 1240). For convenience of description, the slot provided in the first signal wire 1220 will be referred to as a first slot 1222, and the slot provided in the second signal wire 1240 will be referred to as a second slot 1242. In addition, unless otherwise specified, the description of the first slot 1222 is equally or symmetrically applicable to the second slot 1242, and thus the first slot 1222 will be mainly described.

According to various embodiments, the first slot 1222 may be provided by removing a partial area of the first signal wire 1220. For example, the first slot 1222 may be provided by removing a portion of an upper (the +Z-axis direction) area of the first signal wire 1220 when the flexible connecting member 1200 is viewed from a cross section (viewed in parallel to the X axis). Alternatively, the depth of the first slot 1222 may be provided to correspond to the depth of the first signal wire 1220 (that is, by removing all the area of the first signal wire 1220 corresponding to the first slot 1222). In an embodiment, a length (the length in the Y-axis direction) of the first slot 1222 may be smaller than a length (the length in the Y-axis direction) of the first signal wire 1220. In other words, it may be expressed that the first slot 1222 does not completely divide the first signal wire 1220 in the length direction (the Y-axis direction), but only divides the first signal wire 1220 only in a predetermined area in the length direction (the Y-axis direction).

According to various embodiments, the width of the first slot 1222 in the short side direction (the Y-axis direction) may be determined in consideration of a signal transmission characteristic or crosstalk reduction performance of the flexible connecting member 1200. In addition, the width of the first slot 1222 in the short side direction (the Y-axis direction) may be determined in consideration of the widths of remaining areas of the first signal wire 1220 remaining after providing the width in the short side direction (Y-axis direction) or the first slot 1222. For example, the first slot 1222 may divide the first signal wire 1220 into three portions in the length direction (the X-axis direction). In an embodiment (see FIG. 12B), the widths of the first slot 1222 and the first signal wires 1220 on the left side (the +Y-axis direction) and on the right side (the -Y-axis direction) of the first slot 1222 may correspond to each other. For example, the widths of the first slot 1222 and the areas on both sides of the first signal wire 1220 divided by the first slot 1222 may have a ratio of 1:1:1. However, this is an example, and as described above, the width of the first slot 1222 may be changed in consideration of the signal transmission characteristic or crosstalk reduction performance of the flexible connecting member 1200.

According to various embodiments, the first slot 1222 may have various shapes. In an embodiment, the first slot 1222 may have a polygonal shape. For example, the first slot 1222 may have a rectangular or hexagonal shape. In some embodiments, the first slot 1222 may have a circular or oval shape.

According to various embodiments, the width, length, and/or depth of the first slot 1222 may be determined in consideration of the target of a signal transmission characteristic or crosstalk reduction performance of the flexible connecting member 1200.

According to various embodiments (see FIGS. 13A and 13B), the scattering parameter (S-parameter) of the flexible connecting member 1200 may be changed depending on whether the slots 1222 and 1224 are provided. In the embodiment illustrated in FIGS. 13A and 13B, a 3-dimensional electromagnetic field simulation for obtaining an S-parameter was carried out in which the first signal wire 1220 was regarded as an aggressor and the second signal wire 1240 was regarded as a victim. In addition, near-end crosstalk (NEXT) and far-end crosstalk (FEXT) were derived from the above-mentioned S-parameter.

According to various embodiments, it can be seen that, when the slots 1222 and 1242 were provided, NEXT performance and FEXT performance are improved compared to those in the case where the slots 1222 and 1242 were not provided. For example, in the NEXT test results, it was found that the crosstalk performance was improved in all the frequency band, and the crosstalk was reduced by up to about 2.2 dB. In addition, in the FEXT test results, it was found that the crosstalk performance was improved in all the frequency bands, and the crosstalk was reduced by up to about 4.02 dB.

The test results of FIGS. 13A and 13B exemplify the case where the signal wires (e.g., the first signal wire 1220 and/or the second signal wire 1240) have a length of 5 mm, and it was confirmed that as the length of the first signal wire 1220 and/or the second signal wire 1240 increased, the crosstalk reduction effect was improved. It may be expressed that, by providing the slot 1222 and/or the slot 1242 in the signal wire 1220 and/or the signal wire1240, it is possible to ensure stable signal performance while reducing the metal density of the flexible connecting member 1200.

In the foregoing detailed description of this document, specific embodiments have been described. However, it will be evident to a person ordinarily skilled in the art that various modifications can be made.

## Claims

1. A flexible connecting member (450, 550, 900), in particular, a flexible printed circuit board, FPCB, comprising:
a first protective layer (902);
a wiring layer (903) disposed under the first protective layer (902); and
a second protective layer (908) disposed under the wiring layer (903),
wherein the wiring layer (903) includes a support layer (906) configured to support a plurality of wires and a dielectric layer (904) that at least partially covers the plurality of wires,
the plurality of wires include a first ground wire (910) disposed on the support layer (906), a second ground wire (950) disposed in parallel with the first ground wire (910), a first signal wire (920) disposed between the first ground wire (910) and the second ground wire (950), a second signal wire (940) disposed between the first ground wire (910) and the second ground wire (950), and a common ground wire (930) disposed between the first signal wire (920) and the second signal wire (940), and
when viewed from above the flexible connecting member (450, 550, 900), the dielectric layer (904) includes a permittivity change area (905) formed to at least partially overlap the common ground wire (930), and the permittivity change area (905) has a permittivity different from that of the dielectric layer (904) around the permittivity change area (905),
**characterised in that** the permittivity change area (905) has a width (L₁) greater than a width of the common ground wire (930), but smaller than a width between the first signal wire (920) and the second signal wire (940).

2. The flexible connecting member (450, 550, 900) of claim 1, wherein the permittivity change area (905) is formed by removing at least a portion of the dielectric layer (904).

3. The flexible connecting member (450, 550, 900)of claim 1 or 2, wherein the permittivity change area (905) has a permittivity lower than a permittivity of the dielectric layer (904) around the permittivity change area (905).

4. The flexible connecting member (450, 550, 900) of any one of the preceding claims, wherein the permittivity change area (905) is formed of a material different from a material of the dielectric layer (904) around the permittivity change area (905).

5. The flexible connecting member (450, 550, 900) of any one of the preceding claims, wherein the permittivity change area (905) is filled with air.

6. The flexible connecting member (450, 550, 900) of claim 1, wherein the width between the first signal wire (920) and the second signal wire (940) is a distance between an inner edge of the first signal wire (920) and an inner edge of the second signal wire (940).

7. The flexible connecting member (450, 550, 900) of claim 1, wherein the width between the first signal wire (920) and the second signal wire (940) is a distance between an outer edge of the first signal wire (920) and an outer edge of the second signal wire (940).

8. The flexible connecting member (450, 550, 900) of any one of the preceding claims, wherein the permittivity change area (905) has a depth (T₁) determined in consideration of a thickness of the dielectric layer (904) and a thickness of the common ground wire (930)signal transmission characteristic of the flexible connecting member (450, 550, 900).

9. The flexible connecting member (450, 550, 900) of claim 8, wherein the depth (T₁) of the permittivity change area (905) is determined to be less than a length obtained by subtracting a thickness of the common ground wire (930) from a maximum thickness of the dielectric layer (904) such that the common ground wire (930) is not exposed to an outside of the dielectric layer (904).

10. The flexible connecting member (450, 550, 900) of any one of the preceding claims, wherein the first protective layer (902) and the wiring layer (903) are spaced apart from each other by a predetermined distance.

11. The flexible connecting member (450, 550, 900) of any one of the preceding claims, wherein the wiring layer (903) and the second protective layer (908) are spaced apart from each other by a predetermined distance.

12. An electronic device (101, 400) comprising:
a housing (300, 420); and
the flexible connecting member (450, 550, 900) of any one of the preceding claims, the flexible connecting member (450, 550, 900) being disposed inside the housing (300, 420).

## Patentansprüche

1. Flexibles Verbindungselement (450, 550, 900), insbesondere eine flexible Leiterplatte (kurz: FPCB), umfassend:
eine erste Schutzschicht (902);
eine unter der ersten Schutzschicht (902) angeordnete Verdrahtungsschicht (903); und
eine unter der Verdrahtungsschicht (903) angeordnete zweite Schutzschicht (908),
wobei die Verdrahtungsschicht (903) eine Trägerschicht (906), die zum Tragen mehrerer Drähte konfiguriert ist, und eine dielektrische Schicht (904) umfasst, die die mehreren Drähte zumindest teilweise bedeckt,
wobei die mehreren Drähte einen ersten Erdungsdraht (910), der auf der Trägerschicht (906) angeordnet ist, einen zweiten Erdungsdraht (950), der parallel zum ersten Erdungsdraht (910) angeordnet ist, einen ersten Signaldraht (920), der zwischen dem ersten Erdungsdraht (910) und dem zweiten Erdungsdraht (950) angeordnet ist, einen zweiten Signaldraht (940), der zwischen dem ersten Erdungsdraht (910) und dem zweiten Erdungsdraht (950) angeordnet ist, und einen gemeinsamen Erdungsdraht (930), der zwischen dem ersten Signaldraht (920) und dem zweiten Signaldraht (940) angeordnet ist, umfasst, und
wobei von oben auf das flexible Verbindungselement (450, 550, 900) betrachtet, die dielektrische Schicht (904) einen Bereich mit veränderter Permittivität (905) umfasst, der so ausgebildet ist, dass er den gemeinsamen Erdungsdraht (930) zumindest teilweise überlappt, wobei der Bereich mit veränderter Permittivität (905) eine Permittivität aufweist, die sich von der Permittivität der dielektrischen Schicht (904) um den Bereich mit veränderter Permittivität (905) herum unterscheidet,
**dadurch gekennzeichnet, dass**
der Bereich mit veränderter Permittivität (905) eine Breite (L₁) aufweist, die größer ist als eine Breite des gemeinsamen Erdungsdrahtes (930), aber kleiner als eine Breite zwischen dem ersten Signaldraht (920) und dem zweiten Signaldraht (940).

2. Flexibles Verbindungselement (450, 550, 900) nach Anspruch 1, wobei der Bereich mit veränderter Permittivität (905) durch Entfernen mindestens eines Abschnitts der dielektrischen Schicht (904) erzeugt wird.

3. Flexibles Verbindungselement (450, 550, 900) nach Anspruch 1 oder 2, wobei der Bereich mit veränderter Permittivität (905) eine Permittivität aufweist, die niedriger ist als die Permittivität der dielektrischen Schicht (904) um den Bereich mit veränderter Permittivität (905) herum.

4. Flexibles Verbindungselement (450, 550, 900) nach einem der vorstehenden Ansprüche, wobei der Bereich mit veränderter Permittivität (905) aus einem Material gebildet ist, das sich von einem Material der dielektrischen Schicht (904) um den Bereich mit veränderter Permittivität (905) herum unterscheidet.

5. Flexibles Verbindungselement (450, 550, 900) nach einem der vorstehenden Ansprüche, wobei der Bereich mit veränderter Permittivität (905) mit Luft gefüllt ist.

6. Flexibles Verbindungselement (450, 550, 900) nach Anspruch 1, wobei die Breite zwischen dem ersten Signaldraht (920) und dem zweiten Signaldraht (940) ein Abstand zwischen einer Innenkante des ersten Signaldrahts (920) und einer Innenkante des zweiten Signaldrahts (940) ist.

7. Flexibles Verbindungselement (450, 550, 900) nach Anspruch 1, wobei die Breite zwischen dem ersten Signaldraht (920) und dem zweiten Signaldraht (940) ein Abstand zwischen einer Außenkante des ersten Signaldrahts (920) und einer Außenkante des zweiten Signaldrahts (940) ist.

8. Flexibles Verbindungselement (450, 550, 900) nach einem der vorstehenden Ansprüche, wobei der Bereich mit veränderter Permittivität (905) eine Tiefe (T₁) aufweist, die unter Berücksichtigung einer Dicke der dielektrischen Schicht (904) und einer Dicke des gemeinsamen Erdungsdrahtes (930) sowie der Signalübertragungseigenschaften des flexiblen Verbindungselements (450, 550, 900) festgelegt wird.

9. Flexibles Verbindungselement (450, 550, 900) nach Anspruch 8, wobei die Tiefe (T₁) des Bereichs mit veränderter Permittivität (905) so festgelegt ist, dass sie kleiner ist als eine Länge, die durch Subtrahieren einer Dicke des gemeinsamen Erdungsdrahts (930) von einer maximalen Dicke der dielektrischen Schicht (904) erhalten wird, so dass der gemeinsame Erdungsdraht (930) nicht an einer Außenseite der dielektrischen Schicht (904) freiliegt.

10. Flexibles Verbindungselement (450, 550, 900) nach einem der vorstehenden Ansprüche, wobei die erste Schutzschicht (902) und die Verdrahtungsschicht (903) durch einen vorbestimmten Abstand voneinander beabstandet sind.

11. Flexibles Verbindungselement (450, 550, 900) nach einem der vorstehenden Ansprüche, wobei die Verdrahtungsschicht (903) und die zweite Schutzschicht (908) durch einen vorbestimmten Abstand voneinander beabstandet sind.

12. Elektronisches Gerät (101, 400), umfassend:
ein Gehäuse (300, 420); und
das flexible Verbindungselement (450, 550, 900) nach einem der vorstehenden Ansprüche, wobei das flexible Verbindungselement (450, 550, 900) innerhalb des Gehäuses (300, 420) angeordnet ist.

## Revendications

1. Élément de liaison flexible (450, 550, 900), en particulier, une carte de circuit imprimé flexible, FPCB, comprenant :
une première couche protectrice (902) ;
une couche de câblage (903) disposée au-dessous de la première couche protectrice (902) ; et
une seconde couche protectrice (908) disposée au-dessous de la couche de câblage (903),
dans lequel la couche de câblage (903) comporte une couche de support (906) configurée pour soutenir une pluralité de câbles et une couche diélectrique (904) qui au moins couvert partiellement la pluralité de câbles,
la pluralité de câbles comporte un premier câble de terre (910) disposé sur la couche de support (906), un second câble de terre (950) disposé en parallèle au premier câble de terre (910), un premier câble de signal (920) disposé entre le premier câble de terre (910) et le second câble de terre (950), un second câble de signal (940) disposé entre le premier câble de terre (910) et le second câble de terre (950), et un câble de terre commun (930) disposé entre le premier câble de signal (920) et le second câble de signal (940), et
lorsqu'il est vu de dessus de l'élément de liaison flexible (450, 550, 900), la couche diélectrique (904) comporte une zone de changement de permittivité (905) formée pour au moins chevaucher partiellement le câble de terre commun (930), et la zone de changement de permittivité (905) a une permittivité différente de celle de la couche diélectrique (904) autour de la zone de changement de permittivité (905),
**caractérisé en ce que**
la zone de changement de permittivité (905) a une largeur (L₁) supérieure à une largeur du câble de terre commun (930), mais inférieure à une largeur entre premier câble de signal (920) et le second câble de signal (940).

2. Élément de liaison flexible (450, 550, 900) selon la revendication 1, dans lequel la zone de changement de permittivité (905) est formée en supprimant au moins une partie de la couche diélectrique (904).

3. Élément de liaison flexible (450, 550, 900) selon la revendication 1 ou 2, dans lequel la zone de changement de permittivité (905) a une permittivité inférieure à une permittivité de la couche diélectrique (904) autour de la zone de changement de permittivité (905).

4. Élément de liaison flexible (450, 550, 900) selon l'une quelconque des revendications précédentes, dans lequel la zone de changement de permittivité (905) est formée d'un matériau différent d'un matériau de la couche diélectrique (904) autour de la zone de changement de permittivité (905).

5. Élément de liaison flexible (450, 550, 900) selon l'une quelconque des revendications précédentes, dans lequel la zone de changement de permittivité (905) est remplie d'air.

6. Élément de liaison flexible (450, 550, 900) selon la revendication 1, dans lequel la largeur entre le premier câble de signal (920) et le second câble de signal (940) est une distance entre un bord intérieur du premier câble de signal (920) et un bord intérieur du second câble de signal (940).

7. Élément de liaison flexible (450, 550, 900) selon la revendication 1, dans lequel la largeur entre le premier câble de signal (920) et le second câble de signal (940) est une distance entre un bord extérieur du premier câble de signal (920) et un bord extérieur du second câble de signal (940).

8. Élément de liaison flexible (450, 550, 900) selon l'une quelconque des revendications précédentes, dans lequel la zone de changement de permittivité (905) a une profondeur (T₁) déterminée compte tenue d'une épaisseur de la couche diélectrique (904) et d'une épaisseur du câble de terre commun (930) et une caractéristique de transmission de signal de l'élément de liaison flexible (450, 550, 900).

9. Élément de liaison flexible (450, 550, 900) selon la revendication 8, dans lequel la profondeur (T₁) de la zone de changement de permittivité (905) est déterminée pour être moins qu'une longueur obtenue en soustrayant une épaisseur du câble de terre commun (930) à partir d'une épaisseur maximale de la couche diélectrique (904) de telle sorte que le câble de terre commun (930) ne soit pas exposé à un extérieur de la couche diélectrique (904).

10. Élément de liaison flexible (450, 550, 900) selon l'une quelconque des revendications précédentes, dans lequel la première couche protectrice (902) et la couche de câblage (903) sont mutuellement espacées par une distance prédéterminée.

11. Élément de liaison flexible (450, 550, 900) selon l'une quelconque des revendications précédentes, dans lequel la couche de câblage (903) et la seconde couche protectrice (908) sont mutuellement espacées par une distance prédéterminée.

12. Dispositif électronique (101, 400) comprenant :
un boîtier(300, 420) ; et
l'élément de liaison flexible (450, 550, 900) selon l'une quelconque des revendications précédentes, l'élément de liaison flexible (450, 550, 900) étant disposé à l'intérieur du boîtier (300, 420).
